# EUROPEAN PATENT SPECIFICATION

(11) **EP 3 182 079 B1**
(45) Date of publication and mention of the grant of the patent: **23.08.2023**
(21) Application number: 15199891.1
(22) Date of filing: 14.12.2015
(51) Int. Cl.: H01L 27/144, G01J 3/26, G01J 3/02, H01L 27/146, H01L 31/00, G02B 5/28, G01J 3/12, G01J 3/28

(54) **OPTICAL SENSING DEVICE AND METHOD FOR MANUFACTURING AN OPTICAL SENSING DEVICE**
VORRICHTUNG ZUR OPTISCHEN MESSUNG UND VERFAHREN ZUR HERSTELLUNG EINER VORRICHTUNG ZUR OPTISCHEN MESSUNG
DISPOSITIF DE DÉTECTION OPTIQUE ET PROCÉDÉ DE FABRICATION D'UN TEL APPAREIL

(43) Date of publication of application: 21.06.2017
(73) Proprietor: ams AG, 8141 Premstätten (AT)
(72) Inventor: Enichlmair, Hubert, 8044 Weinitzen (AT); Eilmsteiner, Gerhard, 8700 Leoben (AT)
(74) Representative: Epping - Hermann - Fischer

(56) References cited:
- EP-A1- 2 522 968
- WO-A1-95/17690
- CA-A1- 2 376 747
- US-A1- 2007 058 055
- US-B1- 7 119 960

## Description

The invention relates to an optical sensing device, in particular a hyperspectral optical sensing device, and a method for manufacturing such an optical sensing device.

Hyperspectral optical sensing devices may for example be used to analyze a spectral composition of light. To this end, the sensing device may detect incident light and generate information about a distribution of the light intensity corresponding to several narrow spectral bands within one larger spectral range. Therein, the larger spectral range may for example have a width in the order of hundred or few hundreds of nanometers, while the narrow spectral bands may have a width in the order of several nanometers.

Existing approaches for hyperspectral optical sensing devices may for example suffer from drawbacks such as a limited accuracy, vulnerability due to moving parts and/or high complexity due to signal processing for example to unfold spectral information. Manufacturing semiconductor-based hyperspectral sensing devices may also require a high mask count, deep UV capability for lithography and/or a tight control of critical dimensions.

In document US 2007/0058055 A1 a solid state imaging device with a plurality of photodetectors and a color filter is described.

In document EP 2522968 A1 an integrated circuit for an imaging system with an array of optical sensors and an array of optical filters is described.

US 7119960 B1 discloses high performance optical edge and laser-line filters. The laser-line filters have an extremely narrow transmission bandwidth. The filter comprises a bandpass section to define the passband. It further comprises a blocker section to provide additional blocking at wavelengths further away from the passband. The bandpass section comprises a sequence of dielectric layers forming a sequence of Fabry-Perot cavities combined with appropriate "coupling layer" spacers between them.

CA 2376747 A1 discloses an instrument for measuring the water content in skin. Near-infrared light reflects against the skin and the water content correlates with the amount of light absorbed. A quartz-halogen lamp is used as a light source for the instrument and two bandpass filters are used to select the two measurement wavelengths. In one embodiment a multilayer dielectric interference filter is used, which comprises a substrate, reflecting stacks a decoupling layer, a compensating layer and Fabry-Perot cavities.

It is therefore an object to provide an improved concept for an optical sensing device that overcomes the above-mentioned disadvantages.

This object is achieved by the subject matter of the independent claims. Further implementations and embodiments are the subject matter of the dependent claims.

According to the improved concept, a hyperspectral optical sensing device uses several dielectric filter elements which are integrated together with a photodetector array on a single semiconductor chip. The filter elements are arranged to cover respective photodetectors of the photodetector array. Each filter element comprises corresponding sections of a lower and an upper dielectric mirror and a spacer element arranged between the dielectric mirrors. The spacer elements are formed by several dielectric spacer layers being structured by means of a lift-off technique. Therein, a primary spacer layer covers all of the photodetectors. A first spacer layer comprises a segment covering half of the photodetectors. A second spacer layer comprises two segments, each of them covering a quarter of the photodetectors and so forth. A band-pass filter and a decoupling layer are arranged below the lower dielectric mirror to cut off unwanted portions of the pass-bands of the individual filter elements.

According to the improved concept, an optical sensing device, in particular a hyperspectral optical sensing device, is provided. The optical sensing device comprises a semiconductor substrate carrying a photodetector array with at least a first and a second photodetector and a filter stack arranged on the substrate and covering the photodetector array. The filter stack comprises a band-pass filter, a decoupling layer arranged on the band-pass filter and a lower dielectric mirror arranged on the decoupling layer. Each of the band-pass filter, the decoupling layer and the lower dielectric mirror covers the photodetector array, in particular covers all photodetectors comprised by the photodetector array.

The filter stack further comprises a spacer stack. The spacer stack comprises a primary spacer layer arranged on the lower dielectric mirror, comprising or consisting of a first dielectric material and covering the photodetector array, in particular covering all photodetectors comprised by the photodetector array. The spacer stack further comprises a first spacer layer comprising or consisting of the first dielectric material, wherein a first segment of the first spacer layer is arranged on the primary spacer layer and covers the second photodetector but does not cover the first photodetector. The filter stack further comprises an upper dielectric mirror arranged on the spacer stack. The upper dielectric mirror covers the photodetector array, in particular covers all photodetectors comprised by the photodetector array.

The upper and the lower dielectric mirror together with the primary spacer layer and the first spacer layer form at least two filter elements, that may also be denoted as spectral selectors, including a first filter element arranged above and covering the first photodetector and a second filter element arranged above and covering the second photodetector.

According to some implementations, the first filter element is formed by a section of the lower dielectric mirror covering the first photodetector, a first spacer element and a section of the upper dielectric mirror covering the first photodetector. The first spacer element consists of a section of the primary spacer layer covering the first photodetector. The second filter element is formed by a section of the lower dielectric mirror covering the second photodetector, a second spacer element and a section of the upper dielectric mirror covering the second photodetector. The second spacer element consists of a section of the primary spacer layer covering the second photodetector and a section of the first spacer layer covering the second photodetector, namely the first segment of the first spacer layer.

According to some implementations, each part of the first spacer layer, in particular the first segment of the first spacer layer, is in direct contact with the upper dielectric mirror. The section of the primary spacer layer covering the first photodetector is in direct contact with the upper dielectric mirror.

The term section describes a portion of the respective layer that may be connected or not connected to another portion of the respective layer. The term segment describes a section of a respective layer being defined by a photolithographic structuring sequence, for example a lift-off sequence, and, if applicable, being separated from one or more other sections of the respective layer.

The term dielectric mirror refers to a Bragg mirror, also denoted as Bragg reflectors, distributed Bragg mirrors or reflectors or Bragg stacks. Such dielectric mirrors have respective stop-bands. Light with a wavelength within the stop-band hitting the respective mirror is blocked. However, the stop-bands are stop-bands of the isolated mirrors.

The term light may refer to electromagnetic radiation in general including infrared radiation, visible light and/or ultraviolet radiation.

Widths of the stop-bands lie for example in the order of several tens of nanometers, in the order of hundred nanometers few hundreds of nanometers.

The first and the second filter elements each represent a Fabry-Pérot etalon or interferometer. The arrangement of the two dielectric mirrors and the respective spacer elements between the mirrors forming the filter elements has the effect that a first pass-band of the first filter element and a second pass-band of the second filter element are developed. Light with a wavelength within the first pass-band can pass through the first filter element even though the wavelength of the light lies within the stop-bands of the isolated mirrors. Analogously, light with a wavelength within the second pass-band can pass through the second filter element even though the wavelength of the light lies within the stop-bands of the isolated mirrors.

Each of the first and the second pass-band comprises a respective transmission peak at a first and a second pass wavelength, respectively. A value of the first pass wavelength is determined by a thickness of the first spacer element, which is given by a thickness of the primary spacer layer. A value of the second pass wavelength is determined by a thickness of the second spacer element, which is given by a total thickness of the primary spacer layer and the first spacer layer. Apart from the transmission peak at the first and the second wavelength, respectively, the transmission through the filter elements is suppressed within a wavelength range essentially corresponding to the stop-bands of the lower and upper dielectric mirrors.

According to some implementations, the first pass wavelength and the second pass wavelength lie within the stop-band of the lower dielectric mirror and within the stop-band of the upper dielectric mirror.

Widths of the first and the second peak are determined by a reflectivity of the lower dielectric mirror and a reflectivity of the upper dielectric mirror. Widths, for example full widths at half maximum, of the first and the second peak by for example in the order of one or several nanometers.

The first photodetector covered by the first filter element may be used to detect light incident on the optical sensing device with a wavelength within the first pass-band, in particular with a wavelength lying at or close to the first pass wavelength. Analogously, the second photodetector covered by the second filter element may be used to detect light incident on the optical sensing device with a wavelength within the second pass-band, in particular with a wavelength lying at or close to the second pass wavelength.

The lower and the upper dielectric mirror may feature an increased transmission for light with a wavelength lying outside the respective stop-band. Consequently, light with a wavelength lying outside the first or the second pass-band, in particular lying outside the stop-bands, may pass through the first and the second filter element, respectively. It may be unwanted that such light reaches the photodetector array. In particular, if such unwanted light reaches the photodetector array, this may lead to an increased error when determining a spectral composition of the incident light and consequently to a reduced accuracy of the optical sensing device. However, due to the band-pass filter and the decoupling layer such unwanted light may be prevented from reaching the photodetector array.

According to some implementations, the band-pass filter has a pass-band and blocks light with a wavelength lying outside the pass-band of the band-pass filter.

According to some implementations, pass wavelengths of pass-bands of the at least two filter elements, in particular the first pass wavelength and the second pass wavelength, lie within a pass-band of the band-pass filter.

The band-pass filter and the decoupling layer being arranged between the substrate and the lower dielectric mirror are adapted to block unwanted light reaching the photodetector array.

The band-pass filter may for example be adapted such that the pass-band of the band-pass filter extends over a wavelength range corresponding to or approximately corresponding to the stop-band of the lower and/or the upper dielectric mirror. The band-pass filter may be adapted such that light with a wavelength lying not within any of the pass-bands of the filter elements, in particular the first and the second filter element, lie outside the pass-band of the band-pass filter and consequently are blocked.

According to some implementations of the optical sensing device, the band-pass filter is implemented as a dielectric filter.

According to some implementations of the optical sensing device, the band-pass filter consists of band-pass layers containing the first dielectric material and further band-pass layers containing a second dielectric material, wherein the band-pass layers and the further band-pass layers are arranged alternatingly.

The band-pass layers may not necessarily all have the same thickness. Analogously, the further band-pass layers may not necessary all have the same thickness. In particular, the individual thicknesses may be determined by a computer simulation program. The computer simulation program may for example be used to determine the thicknesses of the band-pass layers and the further band-pass layers in an optimal way to achieve a desired pass-band of the band-pass filter.

In general, two optical components being attached to each other may feature a total transmission that differs from a product of their individual transmissions.

However, the decoupling layer decouples the band-pass filter from the filter elements. Thus, a total transmission of one of the filter elements and the band-pass filter is given by or approximately given by a product of a transmission of the band-pass filter and a transmission of the respective filter element.

According to some implementations, the decoupling layer comprises the first dielectric material, the second dielectric material and/or silicon dioxide.

An optical sensing device according to the improved concept may integrate the photodetector array together with the at least two filter elements in one single semiconductor chip or die. Consequently, an advantage of the optical sensing device is that there are no movable parts involved that could cause vulnerability or accelerated wearout.

The primary spacer layer and the first spacer layer both comprise the first dielectric material. However, these layers are individual layers being individually deposited and, if applicable, individually structured by means of a respective photolithographic structuring sequences. For example, the first spacer layer may be structured by means of a respective lift-off sequence for example for defining the first segment of the first spacer layer. Also the primary spacer layer may be structured for example by means of a respective lift-off sequence.

Depositing the primary spacer layer and the first spacer layer individually and structuring them for example by means of lift-off sequences has the advantage that the thicknesses of the primary spacer layer and the first spacer layer and consequently of the first and the second spacer element may be controlled particularly well in this way. For example, the thicknesses may be controlled by means of interferometry during the layer depositions. Hence, an improved accuracy of the optical sensing device may be achieved. In contrast, depositing a common spacer layer and performing selective etching to generate the individual spacer elements may not allow for a comparably tight control of the thicknesses of the spacer elements.

According to the improved concept, all-dielectric filter elements consisting of sections of the lower and upper dielectric mirror and the dielectric spacer elements are utilized. For the individual deposition of the primary spacer layer and the first spacer layer, regular photolithography may be employed. In particular, a deep UV capability of the lithography equipment and/or a particularly tight control of critical dimensions is not required.

Herein, an object covering one of the photodetectors of the photodetector array means that, viewed from a direction perpendicular to a principal plane of the substrate, a projection of the object onto the principal plane covers, in particular fully covers, the respective photodetector. The object may for example be a spacer element, for example the first spacer element, the second spacer element or a further spacer element. The object may also be a section of the lower or the upper dielectric mirror. The principal plane of the substrate may for example correspond to a surface of the substrate where the photodetector array is arranged, that is a surface of the substrate facing the filter stack.

According to some implementations of the optical sensing device, the thickness of the primary spacer layer and the thickness of the first spacer layer differ from each other, in particular the thickness of the first spacer layer is less than the thickness of the primary spacer layer.

According to some implementations, the optical sensing device further comprises a further dielectric layer arranged between the substrate and the band-pass filter and covering the photodetector array.

According to some implementations, the further dielectric layer comprises silicon dioxide.

According to some implementations of the optical sensing device, the photodetector array further comprises a third and a fourth photodetector. The spacer stack further comprises a second spacer layer comprising the first dielectric material, wherein a first segment of the second spacer layer is arranged on the primary spacer layer and covers the third and the fourth photodetector but none of the first and the second photodetector. A second segment of the first spacer layer is arranged on the second spacer layer and covers the fourth photodetector but none of the first, the second and the third photodetector.

A third filter element is formed by a section of the lower dielectric mirror covering the third photodetector, a third spacer element and a section of the upper dielectric mirror covering the third photodetector. The third spacer element consists of a section of the primary spacer layer covering the third photodetector and a section of the second spacer layer covering the third photodetector, namely a section of the first segment of the second spacer layer covering the third photodetector.

A fourth filter element is formed by a section of the lower dielectric mirror covering the fourth photodetector, a fourth spacer element and a section of the upper dielectric mirror covering the fourth photodetector. The fourth spacer element consists of a section of the primary spacer layer covering the fourth photodetector, a section of the second spacer layer covering the fourth photodetector, namely a section of the first segment of the second spacer layer covering the fourth photodetector, and a section of the first spacer layer covering the fourth photodetector, namely the second segment of the first spacer layer.

According to some implementations, the second segment of the first spacer layer is in direct contact with the upper dielectric mirror. The section of the second spacer layer covering the third photodetector is in direct contact with the upper dielectric mirror.

The third and the fourth filter element feature a third and a fourth pass-band, respectively, featuring transmission peaks at a third and a fourth wavelength, respectively. The explanations above with respect to the first and the second pass-band hold analogously for the third and the fourth pass-band. In particular, value of the third wavelength is determined by a thickness of the third spacer element, which is given by a total thickness of the primary spacer layer and the second spacer layer. The value of the fourth wavelength is determined by a thickness of the fourth spacer element, which is given by a total thickness of the primary spacer layer, the first and the second spacer layer.

The second spacer layer may be structured by means of a respective lift-off sequence for example for defining the first segment of the second spacer layer. The lift-off sequence for defining the first spacer layer may at the same time define the first and the second segment of the first spacer layer.

The third and the fourth photodetector covered by the third and the fourth filter element, respectively, may be used to detect light incident on the optical sensing device with a wavelength within the third and the fourth pass-band, respectively.

Consequently, by introducing further spacer layers and doubling the number of photodetectors with each further spacer layer, further implementations of the optical sensor device comprising a number of M filter elements and photodetectors may be derived, wherein M=2^N and N is a positive integer number.

According to some implementations of the optical sensing device, the photodetector array comprises at least M photodetectors including the first and the second photodetector, wherein M is a power of 2, that is M=2^N and N is a positive integer number, for example N is equal to or greater than 2, for example greater than 2. The primary spacer layer covers the at least M photodetectors.

The spacer stack comprises N spacer layers including the first and the second spacer layer and not including the primary spacer layer. Each of the N spacer layers comprises the first dielectric material. The N spacer layers are patterned, in particular by a lift-off technique, and form together with the primary spacer layer M spacer elements including the first and the second spacer element. A first spacer element of the M spacer elements consists of a section of the primary spacer layer covering the first photodetector. Except for the first spacer element, each of the M spacer elements comprises segments of a different subset of the N spacer layers and covers one, in particular exactly one, of the at least M photodetectors. In particular, each of the M spacer elements comprises a segment of each spacer layer of a respective subset of the N spacer layers, the respective subset being different for different spacer elements. Each of the M spacer elements covers a different one of the at least M photodetectors.

In implementations where N is equal to or greater than 2, for example greater than 2, the N spacer layers include also the third and the fourth spacer layer.

Each of the M spacer elements consist of segments, in particular segments covering one of the at least M photodetectors, of a different subset of the N spacer layers and of a section of the primary spacer, in particular a section of the primary spacer layer covering the one of the at least M photodetectors.

Since in general for any set with N elements, there exist exactly M - 1 = 2^N - 1 different subsets, wherein the empty set is not considered a subset, there exist exactly M - 1 different subsets of the N spacer layers. Consequently, for any possible subset of the N spacer layers, one of the M spacer elements being not the first spacer element comprises a segment of each spacer layer of the respective subset of the N spacer layers.

According to some implementations of the optical sensing device, the lower dielectric mirror consists of mirror layers containing the first dielectric material and further mirror layers containing the second dielectric material. The second dielectric material has a second refractive index, which is different from a first refractive index of the first dielectric material. The mirror layers and the further mirror layers of the lower dielectric mirror are arranged alternatingly. Analogously, the upper dielectric mirror consists of mirror layers containing the first dielectric material and further mirror layers containing the second dielectric material, wherein the first and the further mirror layers of the upper dielectric mirrors are arranged alternatingly.

The thicknesses of the mirror layers and the further mirror layers of the respective mirror and the total number of the mirror layers and the further mirror layers comprised by the respective mirror determine a width of the stop-band of the respective mirror, a value of a center wavelength of the stop-band and a reflectivity for light with a wavelength within the stop-band, in particular for light with a wavelength corresponding to the center wavelength, of the respective mirror. The center wavelengths may for example be specified.

According to some implementations of the optical sensing device, the center wavelength of the lower dielectric mirror is, in particular up to manufacturing tolerances, equal to the center wavelength of the upper dielectric mirror.

According to some implementations of the optical sensing device, the width of the stop-band of the lower dielectric mirror is, in particular up to manufacturing tolerances, equal to the width of the stop-band of the upper dielectric mirror.

According to some implementations of the optical sensing device, each of the spacer elements, in particular the first and the second spacer element, is in direct contact with a further mirror layer of the lower dielectric mirror and with a further mirror layer of the upper dielectric mirror.

In other words, the spacer elements comprise the first dielectric material, while the layers of the lower and upper mirrors touching the spacer elements comprise the second dielectric material. In this way, the Fabry-Pérot etalons are formed.

According to some implementations of the optical sensing device, the first refractive index is greater than the second refractive index.

Advantages of such implementations may for example include an improved angular dependency with respect to light incident to the optical sensing device. Since the refractive index of the spacer elements is higher, their total thicknesses are smaller. Therefore, deviations from a perpendicular light incidence may have less pronounced effects on the light propagation through the individual spacer elements.

According to some implementations of the optical sensing device, the second refractive index is greater than the first refractive index.

In such implementations, the total thickness of the spacer elements may be greater. Thus, the layers forming the spacer elements, in particular primary spacer layer, the first and the second spacer layer, may be manufactured easier or with an improved accuracy. In particular process variations may have less pronounced effect in this case.

In general, the first and the second refractive index may be wavelength dependent. That is, the statement that first refractive index is greater than the second refractive index or vice versa requires a comparison of the first and the second refractive index at the same wavelength. The above-mentioned examples, the first refractive index is for example greater than the second refractive index or vice versa for light with a specified wavelength, for example for light with a wavelength corresponding to the center wavelength. Alternatively, the first refractive index is for example greater than the second refractive index or vice versa for light with a wavelength within a specified range, for example the stop-band of one of the upper and the lower dielectric mirror.

According to some implementations of the optical sensing device, at least some of the mirror layers and at least some of the further mirror layers of the lower dielectric mirror have a thickness corresponding to an optical distance being equal to one quarter of the center wavelength. At least some of the mirror layers and at least some of the further mirror layers of the upper dielectric mirror have a thickness corresponding to an optical distance being equal to one quarter of the center wavelength.

According to some implementations of the optical sensing device, at least one of the mirror layers or the further mirror layers of the of the lower dielectric mirror has a thickness corresponding to an optical distance being equal to, in particular up to a respective manufacturing tolerance, one half of the center wavelength.

According to some implementations, one of said at least one of the mirror layers or the further mirror layers of the lower dielectric mirror is arranged adjacent to the decoupling layer.

According to some implementations, one of said at least one of the mirror layers or the further mirror layers of the lower dielectric mirror is arranged adjacent to the spacer stack, in particular to the primary spacer layer.

According to some implementations of the optical sensing device, at least one of the mirror layers or the further mirror layers of the of the upper dielectric mirror has a thickness corresponding to an optical distance being equal to, in particular up to a respective manufacturing tolerance, one half of the center wavelength.

According to some implementations, one of said at least one of the mirror layers or the further mirror layers of the of the upper dielectric mirror is arranged on a side of the upper dielectric mirror opposite to the spacer stack.

According to some implementations, one of said at least one of the mirror layers or the further mirror layers of the of the upper dielectric mirror is arranged adjacent to the spacer stack.

According to some implementations of the optical sensing device, all of the mirror layers and the further mirror layers of the lower and of the upper dielectric mirror have a thickness corresponding to, in particular up to a respective manufacturing tolerance, an optical distance being equal to one quarter of the center wavelength.

An advantage of such implementations is that a reflectivity of a dielectric mirror at the center wavelength is, for a fixed total number of mirror layers and further mirror layers, maximum in this case. This in turn results in a reduced with of the pass-bands of the filter elements.

The number of mirror layers and further mirror layers comprised by one of the upper and lower dielectric mirrors also has an effect on the reflectivity of the respective mirror and consequently on the width of the pass-bands of the filter elements. In particular, the smaller the total number of mirror layers and further mirror layers of a dielectric mirror, the smaller the reflectivity of the mirror and the wider the transmission peaks of the pass-bands of the filter elements and vice versa.

According to some implementations of the optical sensing device, the number of the mirror layers of the lower dielectric mirror is equal to the number of the further mirror layers of the lower dielectric mirror.

According to some implementations of the optical sensing device, the number of the mirror layers of the upper dielectric mirror is equal to the number of the further mirror layers of the upper dielectric mirror.

According to some implementations of the optical sensing device, the first dielectric material comprises silicon dioxide and the second dielectric material comprises at least one of: niobium pentoxide, titanium dioxide, hafnium oxide, silicon nitride, amorphous silicon.

According to some implementations of the optical sensing device, the second dielectric material comprises silicon dioxide and the first dielectric material comprises at least one of: niobium pentoxide, titanium dioxide, hafnium oxide, silicon nitride, amorphous silicon.

According to some implementations of the optical sensing device, the photodetector array is implemented as an array of photodiodes or as an array of charge-coupled device, CCD, elements. Consequently, the first, the second, third and/or the fourth photodetector may be implemented as photodiodes or CCD elements, respectively. In particular, each of the photodetectors may comprise one or more photodetectors or may comprise one or more CCD elements.

According to some implementations of the optical sensing device, the first and the second photodetector are configured to detect light incident on the optical sensing device and passing through the upper dielectric mirror, the spacer stack and the lower dielectric mirror. The first and the second photodetector are further configured to generate a first channel signal and a second channel signal, respectively, based on the detect light.

In particular, the first, and the second photodetector detect light passing through the first filter element and the second filter element, respectively, and generate the first and the second channel signal depending on the detect light. The same holds, analogously, for the third and the fourth photodetector.

According to some implementations, the optical sensing device comprises a readout circuit configured to generate, depending on the first and the second channel signals, at least one spectral signal being indicative of a spectral composition of the incident light.

The readout circuit may for example be carried by the substrate. That is, the photodetector array, the filter elements and the readout circuit may be integrated in one single semiconductor die.

The first and the second channel signal correspond to intensities of fractions of the incident light corresponding to the first and the second pass-band, respectively. Thus, the first and the second channel signal may be processed by the readout circuit without the necessity of unfolding the spectral information.

According to the improved concept, also a method for manufacturing an optical sensing device, in particular a hyperspectral optical sensing device, is provided. The method comprises providing a semiconductor wafer with a semiconductor substrate, the substrate carrying a photodetector array with at least a first and the second photodetector. The method comprises depositing a band-pass filter, depositing a decoupling layer on the band-pass filter and depositing a lower dielectric mirror on the decoupling layer. Therein, each of the band-pass filter, the decoupling layer and the lower dielectric mirror covers the photodetector array.

The method further comprises depositing a spacer stack, the deposition of the spacer stack comprising depositing on the lower dielectric mirror a primary spacer layer comprising a first dielectric material and covering the photodetector array. The deposition of the spacer stack further comprises depositing and structuring by means of a first lift-off sequence a first spacer layer comprising the first dielectric material, wherein a first segment of the first spacer layer is arranged on the primary spacer layer and covers the second photodetector but does not cover the first photodetector. The method further comprises depositing an upper dielectric mirror on the spacer stack.

According to some implementations, the method further comprises depositing a further dielectric layer on the substrate. The band-pass filter is deposited on the further dielectric layer. The further dielectric layer covers the photodetector array.

According to some implementations of the method, the photodetector array further comprises a third and a fourth photodetector. The deposition of the spacer stack further comprises, before depositing the first spacer layer, depositing and structuring by means of a second lift-off sequence a second spacer layer comprising the first dielectric material. A first segment of the second spacer layer is arranged on the primary spacer layer and covers the third and the fourth photodetector but none of the first and the second photodetector. A second segment of the first spacer layer is arranged on the second spacer layer and covers the fourth photodetector but none of the first, the second and the third photodetector.

According to some implementations of the method, the photodetector array comprises at least M photodetectors wherein M is a power of 2, that is with M=2^N and N is a positive integer number, for example N is equal to or greater than 2, for example greater than 2. The primary spacer layer covers the at least M photodetectors. The deposition of the spacer stack comprises depositing and structuring by means of N lift-off sequences N spacer layers including the first and the second spacer layer and not including the primary spacer layer. Each of the N spacer layers comprises the first dielectric material and each of the N spacer layers covers a different subset of the M photodetectors, each subset comprising M/2, in particular exactly M/2, of the at least M photodetectors. In implementations where N is equal to or greater than 2, the N spacer layers include also the third and the fourth spacer layer.

Further implementations of the method are readily derived from the various implementations of the optical sensing device and vice versa.

In the following, the improved concept is explained in detail with the aid of exemplary implementations by reference to the drawings. Components that are functionally identical or have an identical effect may be denoted by identical references.

Identical components and/or components with identical effects may be described only with respect to the figure where they occur first and their description is not necessarily repeated in subsequent figures.

In the drawings,
Figure 1A shows an exemplary implementation of an optical sensing device according to the improved concept;
Figures 1B and 1C show a lower and an upper dielectric mirror, respectively, of an exemplary implementation of an optical sensing device according to the improved concept;
Figure 2A shows the transmission of an isolated dielectric mirror as a function of wavelength;
Figures 2B and 2C show the transmission of a filter element of an exemplary implementation of an optical sensing device according to the improved concept as a function of wavelength;
Figure 2D shows the transmission of a plurality of filter elements of an exemplary implementation of an optical sensing device according to the improved concept as a function of wavelength;
Figure 2E shows the transmission of a band-pass filter of an exemplary implementation of an optical sensing device according to the improved concept as a function of wavelength;
Figures 2F and 2G show the transmission of a combination of filter elements and a band-pass filter of an exemplary implementation of an optical sensing device according to the improved concept as a function of wavelength; and
Figure 3A - 3C show results of steps of an exemplary implementation of a method for manufacturing an optical sensing device according to the improved concept.

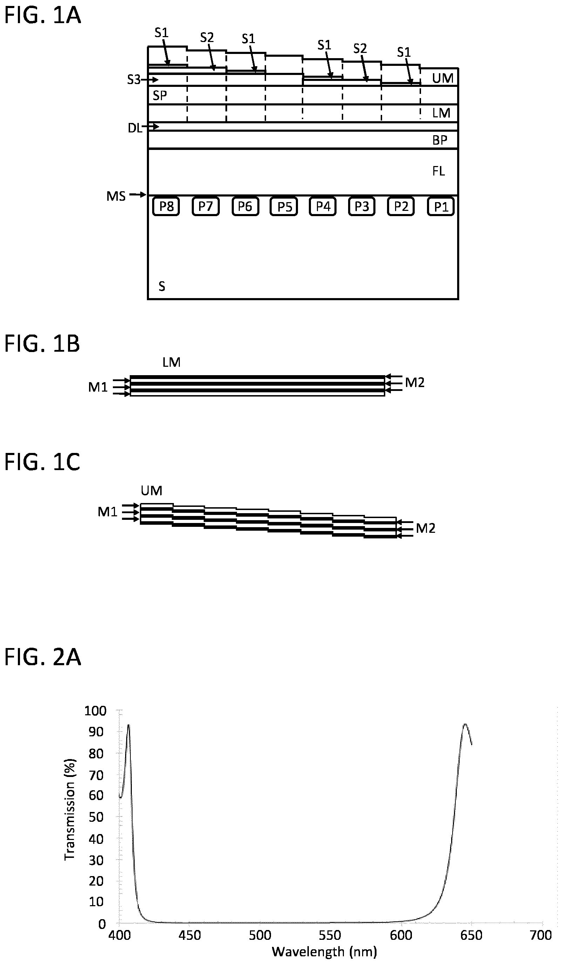

Figure 1A shows an exemplary implementation of an optical sensing device, in particular a hyperspectral optical sensing device, according to the improved concept. The optical sensing device is for example a semiconductor wafer or a part of a semiconductor wafer, an optical sensor die, a part of an optical sensor die or an optical sensor component containing an optical sensor die.

The optical sensing device comprises a semiconductor substrate S and a photodetector array with a plurality of, for example eight, photodetectors P1, ... P8, which are implemented for example as photodiodes and are carried by the substrate S. In particular, the photodetectors P1, ... P8 are arranged on a main surface MS of the substrate. An optional dielectric layer FL is arranged on the main surface of the substrate S. The dielectric layer FL comprises for example silicon dioxide.

The dielectric layer FL may for example be a pre-metallization dielectric layer or an inter metal dielectric layer. The dielectric layer FL may serve for isolating current carrying metal layers. The dielectric layer FL may have a thickness of several µm, for example in the order of 8 µm.

The optical sensing device further comprises a band-pass filter BP arranged on the dielectric layer FL. In implementations where the optical sensing device does not comprise the optional dielectric layer FL, the band-pass filter BP is for example arranged on the main surface of the substrate S. The optical sensing device comprises a decoupling layer DL arranged on the band-pass filter BP and a lower dielectric mirror, also denoted as Bragg mirror, LM arranged on the decoupling layer DL. Each of the dielectric layer FL, the band-pass filter BP, the decoupling layer DL and the lower dielectric mirror LM covers all of the photodetectors P1, ... P8.

The optical sensor device further comprises a spacer stack, that is a stack of spacer layers, containing a primary spacer layer SP arranged on the lower dielectric mirror LM and covering all of the photodetectors P1, ... P8. The spacer stack further comprises a first, a second and a third spacer layer S1, S2, S3.

The third spacer layer S3 is arranged on the primary spacer layer SP. The third spacer layer S3 is structured, in particular by means of a third lift-off sequence, such that a segment of the third spacer layer covers the fifth, the sixth, the seventh and the eighth photodetector P5, ..., P8 but none of the first, the second, the third and the fourth photodetector P1, ..., P4.

The second spacer layer S2 is structured, in particular by means of a second lift-off sequence. As a consequence of the structuring, a first segment of the second spacer layer S2 is arranged on the primary spacer layer SP and covers the third and the fourth photodetector P3, P4 but none of the remaining photodetectors P1, P2, P5, ... P8 of the photodetector array. A second segment of the second spacer layer S2 is arranged on the third spacer layer S3 and covers the seventh and the eighth photodetector P7, P8 but none of the remaining photodetectors P1, ... P6 of the photodetector array.

The first spacer layer S1 is structured, in particular by means of a first lift-off sequence. As a consequence of the structuring, a first segment of the first spacer layer S1 is arranged on the primary spacer layer SP and covers the second photodetector P2 but none of the remaining photodetectors P1, P3, ..., P8, of the photodetector array. A second segment of the first spacer layer S1 is arranged on the first segment of the second spacer layer S2 and covers the fourth photodetector P4 but none of the remaining photodetectors P1, P2, P3, P5, ..., P8 of the photodetector array. A third segment of the first spacer layer S1 is arranged on the third spacer layer S3 and covers the sixth photodetector P6 but none of the remaining photodetectors P1, ..., P5, P7, P8 of the photodetector array. A fourth segment of the first spacer layer S1 is arranged on the second segment of the second spacer layer S2 and covers the eighth photodetector P8 but none of the remaining photodetectors P1, ..., P7 of the photodetector array.

The optical sensing device further comprises an upper dielectric mirror, also denoted as Bragg mirror, UM arranged on the spacer stack and covering all of the photodetectors P1, ... P8.

Even though the lower dielectric mirror LM is depicted in Figure 1A as a single block, it consists for example of an alternating stack of mirror layers M1 comprising a first dielectric material and further mirror layers M2 comprising a second dielectric material, as depicted schematically in Figure 1B.

In the example of Figure 1B, the lower dielectric mirror LM comprises three mirror layers M1 and three further mirror layers M2 arranged alternatingly, wherein for example one of the mirror layers M1 is arranged on the decoupling layer and consequently the primary spacer layer SP is arranged on one of the further mirror layers M2.

The mirror layers M1 of the lower dielectric mirror LM may for example all have the same thickness and the further mirror layers M2 of the lower dielectric mirror may for example all have the same thickness, up to respective manufacturing tolerances. The thickness of the mirror layers M 1 and the further mirror layers M2 may for example correspond to an optical distance given by one quarter of a specified center wavelength 10. In particular, the thickness of the mirror layers M1 multiplied with the first refractive index n1 of the first dielectric material may be equal or approximately equal to one quarter of the center wavelength 10. Analogously, the thickness of the further mirror layers M2 multiplied with the second refractive index n2 of the second dielectric material may be equal or approximately equal to one quarter of the center wavelength l0.

The choice of one quarter of the center wavelength l0 leads to a maximum reflectivity of the lower dielectric mirror, in particular for light with a wavelength corresponding to the center wavelength 10.

In some implementations of the optical sensing device, one or more of the mirror layers M1 and/or the further mirror layers M2 may have a thickness corresponding to, up to a respective manufacturing tolerance, an optical distance being equal to one half of the center wavelength 10. These layers are for example arranged adjacent to the decoupling layer DL and/or adjacent to the spacer stack in the case of the lower mirror LM. In the case of the upper mirror UM, these layers are for example arranged on a side of the upper dielectric mirror UM opposite to the spacer stack and/or adjacent to the spacer stack. Said layers may reduce the maximum reflectivity, but may broaden the pass wavelength region of the respective filter element.

The first refractive index n1 of the first dielectric material may for example be smaller than the second refractive index n2 of the second dielectric material.

The first dielectric material may for example comprise silicon dioxide. The refractive index of silicon dioxide, and consequently the first refractive index n1, may then be approximately 1.47 for light with a wavelength of approximately 500 nm.

The second dielectric material may for example comprise niobium pentoxide, titanium dioxide, hafnium oxide, silicon nitride or amorphous silicon. The second refractive index n2 may then correspond to the refractive index of niobium pentoxide, titanium dioxide, hafnium oxide, silicon nitride or amorphous silicon. For light with a wavelength of approximately 500 nm, the refractive index of niobium pentoxide is approximately 2.4, the refractive index of titanium dioxide is approximately 2.35, the refractive index of hafnium oxide is approximately 2.0, the refractive index of silicon nitride is approximately 2.1 and the refractive index of amorphous silicon is approximately 4.8.

In alternative implementations, the second refractive index n2 is smaller than the first refractive index n1. Then, the first dielectric material may comprise niobium pentoxide, titanium dioxide, hafnium oxide, silicon nitride or amorphous silicon and the second dielectric material may comprise silicon dioxide.

In analogy, the upper dielectric mirror UM may as well consist an alternating stack of mirror layers M1 comprising the first dielectric material and further mirror layers M2 comprising the second dielectric material, as depicted schematically in Figure 1C. The upper dielectric mirror UM may for example be composed as the lower dielectric mirror LM but with an inverted sequence of the mirror layers M1 and the further mirror layers M2. That is, one of the further mirror layers M2 of the upper dielectric mirror UM is for example arranged on the spacer stack.

In the example of Figure 1C, the upper dielectric mirror UM comprises three mirror layers M1 and three further mirror layers M2 arranged alternatingly, wherein for example one of the further mirror layers M2 is arranged on the spacer stack.

The numbers and thicknesses of the mirror layers M1 and the further mirror layers M2 comprised by the upper dielectric mirror UM may for example be equal to the numbers and thicknesses of the mirror layers M1 and the further mirror layers M2 comprised by the lower dielectric mirror LM, respectively. In alternative implementations, the upper dielectric mirror UM may contain more or less mirror layers M1 and/or more further mirror layers M2 than the lower dielectric mirror LM.

The arrangement of the mirror layers M1 and the further mirror layers M2 in the upper and the lower dielectric mirror UM, LM imply respective stop-bands of the upper and the lower dielectric mirror UM, LM, in particular of the isolated upper and the lower dielectric mirror UM, LM.

Since a total height of the spacer stack varies locally across the optical sensing device, the individual mirror layers M1 and further mirror layers M2 of the upper dielectric mirror UM may have a step-like profile as depicted in Figures 1A and 1C.

It is pointed out, that the number of mirror layers M1 and further mirror layers M2 of the upper and lower dielectric mirror UM, LM being equal to three, respectively, in Figures 1B and 1C, is to be understood as an example only. In alternative implementations, the number of mirror layers M1 and further mirror layers M2 may be different.

Referring back to Figure 1A, each of the spacer layers SP, S1, S2, S3 comprises the first dielectric material. The arrangement of the spacer stack between the upper and the lower dielectric mirror UM, LM corresponds to a plurality of Fabry-Pérot etalons or filter elements as indicated in Figure 1A by vertical dashed lines.

A first, a second a third, a fourth, a fifth, a sixth, a seventh and an eighth filter element are formed by a first, a second a third, a fourth, a fifth, a sixth, a seventh and an eighth spacer element, respectively, and by sections of the lower dielectric mirror LM and the upper dielectric mirror UM covering the first, the second, the third, the fourth, the fifth, the sixth, the seventh and the eighth photodetector P1, ..., P8, respectively.

The first spacer element is formed by a section of the primary spacer layer SP covering the first photodetector P1. The second spacer element is formed by the first segment of the first spacer layer S1 and a section of the primary spacer layer SP covering the second photodetector P2. The third spacer element is formed by respective sections of the primary spacer layer SP and the first segment of the second spacer layer S2 covering the third photodetector P3. The fourth spacer element is formed by the second segment of the first spacer layer S1 and respective sections of the primary spacer layer SP and the first segment of the second spacer layer S2 covering the fourth photodetector P4.

The fifth spacer element is formed by respective sections of the primary spacer layer SP and the third spacer layer S3 covering the fifth photodetector P5. The sixth spacer element is formed by the third segment of the first spacer layer S1 and respective sections of the primary spacer layer SP and the third spacer layer S3 covering the sixth photodetector P6. The seventh spacer element is formed by respective sections of the primary spacer layer SP, the third spacer layer S3 and the second segment of the second spacer layer S2 covering the seventh photodetector P7. The eighth spacer element is formed by the fourth segment of the first spacer layer S1 and respective sections of the primary spacer layer SP, the third spacer layer S3 and the second segment of the second spacer layer S2 covering the eighth photodetector P8.

Due to the arrangement of the upper and lower dielectric mirrors UM, LM and the spacer elements, light incident on the optical sensing device can pass one of the filter elements only if it has a wavelength within a pass-band of the respective filter element. The pass-bands of the filter elements feature transmission peaks at respective pass wavelengths defined by the thickness of the respective spacer element.

The thicknesses of the spacer layers SP, S1, S2, S3 are for example adapted to result in pass wavelengths arranged around the center wavelength 10, which is defined by the thicknesses of the first and the second mirror layers M1, M2.

A thickness of one of the spacer elements may for example correspond to an optical distance given by one half of the center wavelength 10. Each of the spacer elements may have a thickness corresponding to an optical distance given by one half of the center wavelength 10 multiplied with a respective shift factor. The shift factor may for example lie between 0.1 and 2, for example between 0.5 and 1.5.

In an exemplary implementation, the center wavelength 10 is 500 nm. The first dielectric material may be silicon dioxide and the first refractive index is assumed to be equal to 1.47 in the relevant wavelength range. The primary thickness may be for example be approximately 150 nm / n1 = 102 nm. The first thickness may for example be approximately 25 nm / n1 = 17 nm. The second thickness and the third thickness may be twice and four times the first thickness, respectively, that is 34 nm and 68 nm, respectively. Then the thicknesses of the spacer elements correspond to optical distances of 0.6^{∗}l0/2, 0.7^{∗}l0/2, 0.8^{∗}l0/2, 0.9^{∗}l0/2, l0/2, 1.1^{∗}l0/2, 1.2^{∗}l0/2 and 1.3^{∗}l0/2, respectively.

Apart from the transmission peaks around the pass wavelengths, the pass-bands of the filter elements may for example show an increased transmission for wavelengths outside of the stop-bands of the upper and the lower dielectric mirror UM, LM. It may be not desired that light with a wavelength outside the stop-bands can pass through the filter elements and reach a respective one of the photodetectors P1, ..., P8.

The band-pass filter BP has for example a pass-band corresponding to or approximately corresponding to the stop-bands of the upper and the lower dielectric mirror UM, LM. In addition, the decoupling layer DL arranged between the band-pass filter BP and the lower dielectric mirror LM may have the effect that a transmission of light through one of the filter elements, the decoupling layer DL and the band-pass filter BP corresponds to or approximately corresponds to a transmission of the light through the one of the filter elements multiplied with a transmission of the light through the band-pass filter BP. In this way, light with an undesired wavelength may be prevented from reaching one of the photodetectors P1, ..., P8.

The decoupling layer DL comprises for example first dielectric material. In some implementations, the decoupling layer DL may have a thickness corresponding to an optical distance of approximately l0/1.7.

The band-pass filter consists for example of an alternating stack of band-pass layers containing the first dielectric material and further band-pass layers containing the second dielectric material. Therein, the thicknesses of the band-pass layers and the further band-pass layers are for example adjusted according to a computer simulation used to determine an optimal sequence of thicknesses for achieving the desired pass-band characteristics of the band-pass filter. The band-pass filter may have for example a total thickness in the order of several µm, for example less than 6 µm, for example between 1 µm and 6µm.

The optical sensing device further comprises a readout circuit (not shown) that is for example carried by the substrate S.

If light hits the optical sensing device, respective fractions of the light may pass through one or more of the filter elements and through the band-pass filter BP according to the wavelength of the light and the pass-band of the filter elements. Consequently, the fractions of the light may reach a respective one of the photodetectors P1, ..., P8 and be detected accordingly. The photodetectors P1, ..., P8 may then generate respective channel signals according to the intensity of the light reaching the respective photodetector. The readout circuit may process the channel signals to determine for example a spectral composition of the incident light.

Utilizing the improved concept, it is straightforward to extend the optical sensing device to implementations comprising 16, 32 or a higher power of 2 filter elements and corresponding photodetectors. To this end, further spacer layers comprising the first dielectric material are arranged correspondingly. In general, the primary spacer layer SP and N spacer layers (including the first, the second and the third spacer layer) are necessary to construct M=2^N filter elements in the described way, wherein N is a positive integer.

The wording of an object covering one or more of the photodetectors P1, ... P8 means that, from a direction perpendicular to the main surface MS of the substrate S, a projection of the respective object onto the main surface MS covers, in particular fully covers, the respective one or more of the photodetectors P1, ... P8. The object may for example be one of the filter elements, one of the spacer elements, a section of one of the spacer layers SP, S1, S2, S3, a section of the lower or the upper dielectric mirror, a section of the decoupling layer or a section of the band-pass filter.

Is highlighted that the dimensions, in particular the thicknesses of layers, in Figures 1A to 1C may not be drawn to scale. Furthermore, edges of layers that appear sharp in Figures 1A to 1C, in particular of the dielectric mirrors LM, UM, the spacer layers S1, S2, S3 and the mirror layers ML1, ML2, may be rounded in an actual device. In particular, the outlines and the edges of the mirror layers ML1, ML2 forming the upper dielectric mirror UM are drawn schematically in Figures 1A and 1C. In an actual device, more smooth outlines and edges may result from the manufacturing process.

Figure 2A shows the transmission in percent of an isolated dielectric mirror for light incident on the isolated dielectric filter as a function of the wavelength of the incident light for normal incidence. The mirror for example may be the lower dielectric mirror LM or the upper dielectric mirror UM as described with respect to Figures 1A to 1C.

The transmission of the dielectric mirror is suppressed within a stop-band extending approximately from 420 nm to 620 nm. Outside the stop-band, the transmission is for example increased.

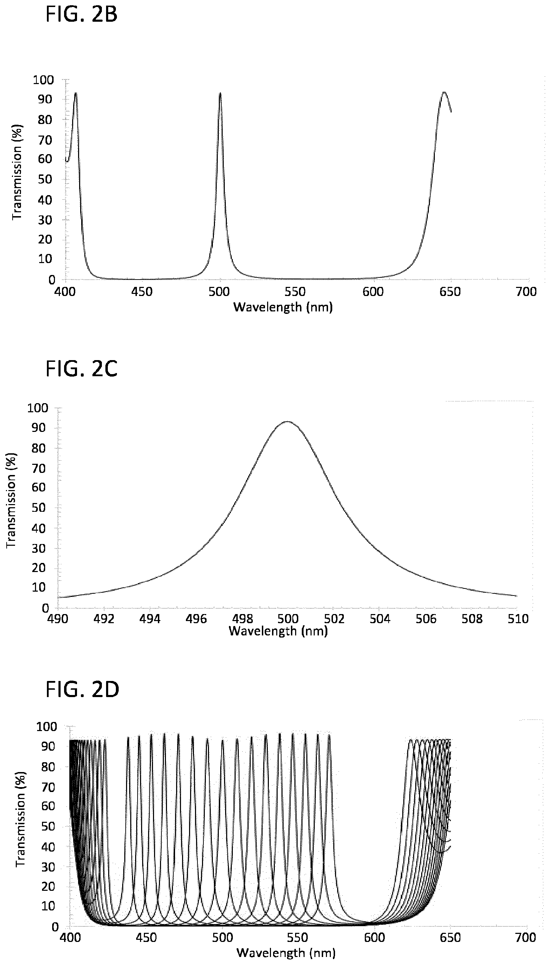

Figures 2B shows the transmission of a filter element of an exemplary implementation of an optical sensing device according to the improved concept for light incident on the filter element as a function of the wavelength of the incident light for normal incidence. The filter element may for example be one of the filter elements of the optical sensing device shown in Figure 1A.

The transmission of the filter element shows a transmission peak around a pass wavelength of approximately 500 nm. Apart from that, the transmission of the filter element is suppressed in a wavelength region from approximately 420 nm to approximately 620 nm, which corresponds for example approximately to a stop-band of the isolated upper dielectric mirror UM and the isolated lower dielectric mirror LM.

The shown pass wavelength of approximately 500 nm may for example correspond to the center wavelength 10 defined by the thicknesses of the mirror layers M1 and the further mirror layers M2 of the upper and the lower dielectric mirror UM, LM. That is, the thickness of each of the mirror layers M1 may for example be equal to or approximately equal to one quarter of the center wavelength 10 divided by the first refractive index n1. If the first dielectric material is for example of silicon dioxide, which has a refractive index of 1.47 for a wavelength of 500 nm, the thickness of each of the mirror layers M1 is approximately 85 nm. Analogously, the thickness of each of the further mirror layers M2 may for example be equal to or approximately equal to one quarter of the center wavelength 10 device by the second refractive index n2. If the second dielectric material is for example niobium pentoxide, which has a refractive index of 2.4 for a wavelength of 500 nm, the thickness of each of the further mirror layers M2 is approximately 52 nm.

As explained above, in alternative implementations one or more of the mirror layers M1 and/or the further mirror layers M2 may have a thickness corresponding to an optical distance being equal to one half of the center wavelength 10.

The thickness of the spacer element may for example be equal to or approximately equal to one half of the center wavelength 10 divided by the first refractive index n1. If the first dielectric material is for example of silicon dioxide, the thickness of the spacer element is approximately 171 nm.

Figure 2C shows a detail of Figure 2B. It can be seen that the transmission peak of the pass-band around the pass wavelength has a full width at half maximum of approximately 5-10 nm, for example approximately 5 nm.

Figure 2D shows respective curves of the transmission of a plurality of filter elements of an exemplary implementation of an optical sensing device according to the improved concept for light incident on the filter elements as a function of the wavelength of the incident light for normal incidence.

Figure 2D shows the transmission curve that is also shown in Figure 2B with a transmission peak at approximately 500 nm. Furthermore, transmission curves of 15 additional filter elements are shown. The resulting 16 transmission curves may for example correspond to transmission curves of 16 filter elements of an optical sensing device according to the improved concept.

The filter elements differ by the thicknesses of their spacer elements. In the example of Figure 2D, the thicknesses of the spacer elements correspond for example to optical distances given by respective shift factors multiplied with one half of the center wavelength 10. The shift factors may be in the shown example 0.65, 0.70, 0.75, ..., 1.35, 1.40.

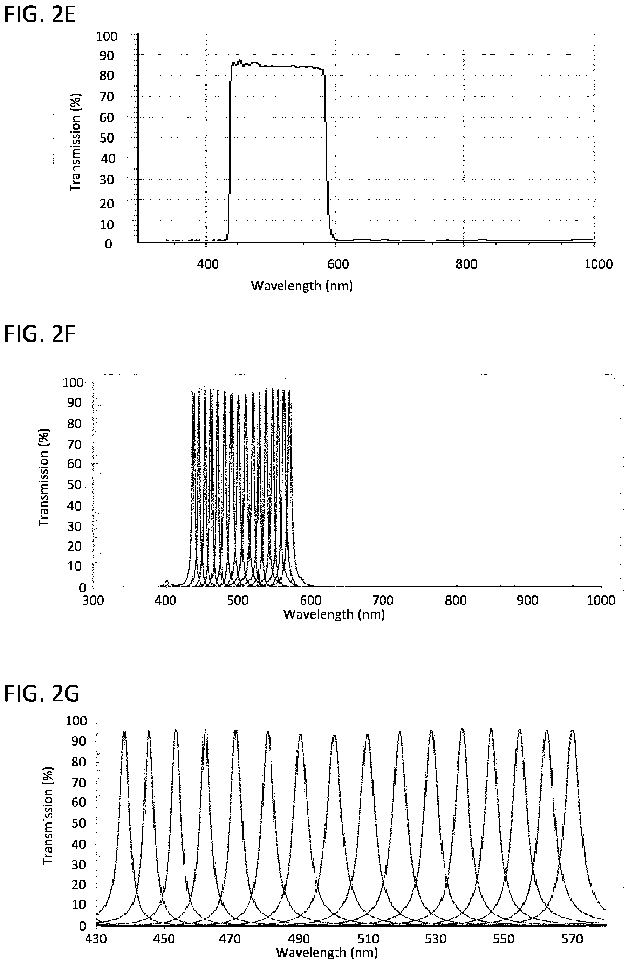

Figure 2E shows transmission of a band-pass filter BP of an exemplary implementation of an optical sensing device according to the improved concept for light incident on the band-pass filter as a function of the wavelength of the incident light for normal incidence.

The shown transmission may correspond to an isolated band-pass filter BP. The transmission is high, in particular lies between 80% and 90%, for light within a pass-band of the band-pass filter BP extending approximately from 430 nm to 590 nm, which corresponds approximately to the stop-bands of the upper and lower dielectric mirrors UM, LM.

Figure 2F shows the transmission of a combination of the filter elements corresponding to Figure 2D, the band-pass filter BP of Figure 2E and a decoupling layer DL arranged between the band-pass filter BP and the filter elements as shown for example in Figure 1A. Transmission is shown as a function of the wavelength of the incident light for normal incidence.

As can be seen from a comparison of Figures 2D, 2E and 2F, the transmission of the filter elements, the band-pass filter BP and the decoupling layer DL corresponds approximately to a product of the transmission of the filter elements and the transmission of the band-pass filter BP. In this way, only the peaks of the pass-bands of the filter elements are present in the resulting transmission curves but not the increased transmission outside the stop-bands of the lower and the upper dielectric mirror LM, UM.

Figure 2G shows a detail of Figure 2F.

It is pointed out that Figures 2A to 2G show results of computer simulations.

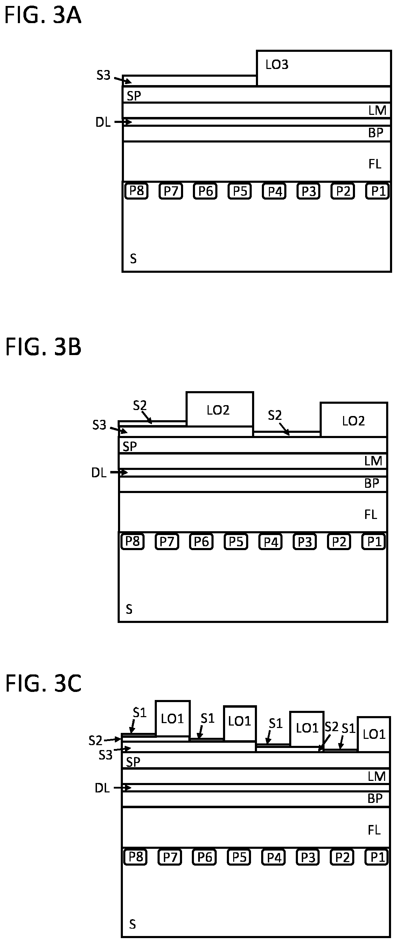

An exemplary implementation of a method for manufacturing an optical sensing device according to the improved concept is explained with respect to Figures 3A to 3C. The optical sensing device shown in Figures 3A to 3C corresponds to the optical sensing device of Figure 1A at or after different steps of manufacturing.

In Figure 3A, the optional dielectric layer FL, the band-pass filter BP, the decoupling layer DL, the lower dielectric mirror LM as well as the primary spacer layer SP have been deposited on the substrate and each of them covers each of the photodetectors P1, ..., P8.

Then, a third sacrificial layer LO3 has been deposited on the primary spacer layer SP and structured to form a third lift-off mask. In particular, after structuring the third sacrificial layer LO3, the third lift-off mask covers the first, the second, the third and the fourth photodetector P1, ... P4, but none of the fifth, the sixth, the seventh and the eighth photodetector P5, ..., P8. Then, the third spacer layer S3 is deposited. In this way, the segment of the third spacer layer S3 is arranged on a section of the primary spacer layer SP that is not covered by the third sacrificial layer LO3. Furthermore, material of the third spacer layer S3 is also deposited on the third sacrificial layer L03, which is not shown in Figure 3A.

In Figure 3B, the third sacrificial layer L03 has been removed together with the material of the third spacer layer S3 deposited on the third sacrificial layer L03. By means of the described lift-off sequence, the segment of the third spacer layer S3 covering the fifth, the sixth, the seventh and the eighth photodetector P5, ..., P8 is left on the primary spacer layer SP.

Then, a second sacrificial layer L02 is deposited and structured to form a second lift-off mask. In particular, after structuring the second sacrificial layer LO2, the second lift-off mask covers the first, the second, the fifth and the sixth photodetector P1, P2, P5, P6 but none of the third, the fourth, the seventh and the eighth photodetector P3, P4, P7, P8. Then, the second spacer layer S2 is deposited. In this way, the first segment of the second spacer layer S2 is arranged on a section of the primary spacer layer SP that is covered neither by the second sacrificial layer LO2 nor by the third spacer layer S3. The second segment of the second spacer layer S2 is arranged on a section of the third spacer layer S3 that is not covered by the second sacrificial layer LO2. Furthermore, material of the second spacer layer S2 is also deposited on the second sacrificial layer L02, which is not shown in Figure 3B.

In Figure 3C, the second sacrificial layer L02 has been removed together with the material of the second spacer layer S2 deposited on the second sacrificial layer L02. By means of the described lift-off sequence, the first segment of the second spacer layer S2 covering the third and the fourth photodetector P3, P4 is left on the primary spacer layer SP. Analogously, the second segment of the second spacer layer S2 covering the seventh and the eighth photodetector P7, P8 is left on the third spacer layer S3.

Then, a first sacrificial layer L01 is deposited and structured to form a first lift-off mask. In particular, after structuring the first sacrificial layer LO1, the first lift-off mask covers the first, the third, the fifth and the seventh photodetector P1, P3, P5, P7 but none of the second, the fourth, the sixth and the eighth photodetector P2, P4, P6, P8. Then, the first spacer layer S1 is deposited. In this way, the first segment of the first spacer layer S1 is arranged on a section of the primary spacer layer SP that is covered neither by the first sacrificial layer LO1 nor by the third spacer layer S3 nor by the second spacer layer S2. The second segment of the first spacer layer S1 is arranged on a section of the first segment of the second spacer layer S2 that is not covered by the first sacrificial layer LO1. The third segment of the first spacer layer S1 is arranged on a section of the third spacer layer S3 that is covered neither by the first sacrificial layer LO1 nor by the second spacer layer S2. The fourth segment of the first spacer layer S1 is arranged on a section of the second segment of the second spacer layer S2 that is not covered by the first sacrificial layer LO1. Furthermore, material of the first spacer layer S1 is also deposited on the first sacrificial layer L01, which is not shown in Figure 3C.

In a subsequent step (not shown), the first sacrificial layer L01 is removed together with the material of the first spacer layer S1 deposited on the first sacrificial layer L01. By means of the described lift-off sequence, the first segment of the first spacer layer S1 covering the second photodetector P2 is left on the primary spacer layer SP and the second segment of the first spacer layer S1 covering the fourth photodetector P4 is left on the first segment of the second spacer layer S2. Further, the third segment of the first spacer layer S1 covering the sixth photodetector P6 is left on the third spacer layer S3 and the fourth segment of the first spacer layer S1 covering the eighth photodetector P8 is left on the second segment of the second spacer layer S2.

The mirror layers M1, the further mirror layers M2, the band-pass layers, the further band-pass layers, the spacer layers S1, S2, S3 and/or the primary spacer layer SP may for example be deposited by means of chemical vapor deposition, ion beam sputtering, electron beam evaporation and/or reactive sputtering.

The described method according to the improved concept may be readily extended for manufacturing an optical sensing device comprising 16, 32 or a higher power of 2 filter elements and corresponding photodetectors. To this end, further spacer layers comprising the first dielectric are deposited correspondingly. In general, the primary spacer layer SP and N spacer layers (including the first, the second and the third spacer layer) are necessary to construct M=2^N filter elements in the described way, wherein N is a positive integer.

In particular, N + 1 photolithography steps and corresponding photolithography masks are necessary for depositing the M spacer elements of the M filter elements. In contrast, if each of the M spacer elements would be deposited or manufactured individually, at least M photolithography masks would be necessary. Thus, the method according to the improved concept may significantly reduce a mask count, in particular for manufacturing a hyperspectral optical sensing device with a large number of channels, filter elements and photodetectors, respectively.

The first, the second and the third sacrificial layers LO1, LO2, LO3 may for example comprise a photoresist or another suitable material for performing the respective lift-off sequences for structuring.

An optical sensor die may also comprise more than one optical sensing device as shown in Figures 1A and 3A to 3C. The additional sensing devices may be implemented analogously to the arrangement of Figure 1A but may feature for example a different center wavelength l0 and/or different pass wavelengths of the filter elements. In this way, a larger section of the light spectrum than possible with only one optical sensor device may be covered with a single optical sensor die. For example, using three optical sensing devices with different center wavelengths, each of the devices covering a spectral range of approximately 100 nm with the respective pass wavelengths of their filter elements, the whole visible light spectrum from approximately 400 nm to approximately 700 nm wavelength may be covered with a single hyperspectral optical sensor die.

### Reference numerals

- S: semiconductor substrate
- S1, S2, S3, SP: spacer layers
- UM, LM: dielectric mirrors
- DL: decoupling layer
- BP: band-pass filter
- FL: dielectric layer
- MS: main surface
- P1, P2, P3, P4, P5, P6, P7, P8: photodetectors
- M1, M2: mirror layers
- LO1, LO2, LO3: sacrificial layers

## Claims

1. Optical sensing device comprising a semiconductor substrate (S) carrying a photodetector array with at least a first and a second photodetector (P1, P2) and a filter stack arranged on the substrate (S) and covering the photodetector array, the filter stack comprising
- a band-pass filter (BP), a decoupling layer (DL) arranged on the band-pass filter (BP) and a lower dielectric mirror (LM) arranged on the decoupling layer (DL), wherein each of the band-pass filter (BP), the decoupling layer (DL) and the lower dielectric mirror (LM) covers the photodetector array;
- a spacer stack comprising
- a primary spacer layer (SP) arranged on the lower dielectric mirror (LM), comprising a first dielectric material and covering the photodetector array; and
- a first spacer layer (S1) comprising the first dielectric material, a first segment of the first spacer layer (S1) being arranged on the primary spacer layer (SP) and covering the second photodetector (P2) but not the first photodetector (P1); and
- an upper dielectric mirror (UM) arranged on the spacer stack, wherein
- filter elements are formed by sections of the spacer stack, the lower dielectric mirror (LM) and the upper dielectric mirror (UM), including a first filter element arranged above and covering the first photodetector (P1) and having a first pass wavelength, and a second filter element arranged above and covering the second photodetector (P2) and having a second pass wavelength,
- the first pass wavelength and the second pass wavelength lie within a pass-band of the band-pass filter (BP), and
- the decoupling layer (DL) is adapted to decouple the band-pass filter (BP) from the filter elements, such that a total transmission of one of the filter elements and the band-pass filter (BP) is given by or approximately given by a product of a transmission of the band-pass filter (BP) and a transmission of the respective filter element.

2. Optical sensing device according to claim 1, wherein the photodetector array further comprises a third and a fourth photodetector (P3, P4) and the spacer stack further comprises
- a second spacer layer (S2) comprising the first dielectric material, a first segment of the second spacer layer (S2) being arranged on the primary spacer layer (SP) and covering the third and the fourth photodetector (P3, P4) but none of the first and the second photodetector (P1, P2);
- a second segment of the first spacer layer (S1) being arranged on the second spacer layer (S2) and covering the fourth photodetector (P4) but none of the first, the second and the third photodetector (P1, P2, P3).

3. Optical sensing device according to one of claims 1 or 2, wherein each of the lower and the upper dielectric mirror (ML, MU) consists of mirror layers (M1), containing the first dielectric material and further mirror layers (M2) containing a second dielectric material with a second refractive index being different from a first refractive index of the first dielectric material, wherein the mirror layers (M1) and the further mirror layers (M2) are arranged alternatingly.

4. Optical sensing device according to claim 3, wherein at least some of the mirror layers (M1) and at least some of the further mirror layers (M2) have a thickness corresponding to an optical distance being equal to one quarter of a specified center wavelength.

5. Optical sensing device according to claim 4, wherein
- a first filter element is formed by a section of the lower dielectric mirror (LM) covering the first photodetector (P1), a section of the primary spacer layer (SP) covering the first photodetector (P1) and a section of the upper dielectric mirror (UM) covering the first photodetector (P1); and
- a second filter element is formed by a section of the lower dielectric mirror (LM) covering the second photodetector (P2), a section of the primary spacer layer (SP) covering the second photodetector (P2), the first segment of the first spacer layer (S1) and a section of the upper dielectric mirror (UM) covering the first photodetector (P1).

6. Optical sensing device according to claim 5, wherein a value of the first pass wavelength of the first filter element is determined by a thickness of the primary spacer layer (SP) and a value of the second pass wavelength of the second filter element is determined by total thickness of the primary spacer layer (SP) and the first spacer layer (S1).

7. Optical sensing device according to claim 6, wherein the first pass wavelength and the second pass wavelength lie within a stop-band of the lower dielectric mirror (LM) and within a stop-band of the upper dielectric mirror (UM).

8. Optical sensing device according to one of claims 3 to 7, wherein the band-pass filter (BP) consists of band-pass layers containing the first dielectric material and further band-pass layers containing the second dielectric material, wherein the band-pass layers and the further band-pass layers are arranged alternatingly.

9. Optical sensing device according to one of claims 1 to 8, wherein the first and the second photodetector (P1, P2) are configured to
- detect light incident on the optical sensing device and passing through the upper dielectric mirror (UM), the spacer stack and the lower dielectric mirror (LM); and
- to generate a first channel signal and a second channel signal, respectively, based on the detected light.

10. Optical sensing device according to claim 9, further comprising a readout circuit configured to generate, depending on the first and the second channel signals, at least one spectral signal indicative of a spectral composition of the incident light.

11. Optical sensing device according to one of claims 1 to 10, wherein
- the photodetector array comprises at least M photodetectors (P1, ..., P8) with M=2^N and N being a positive integer number;
- the primary spacer layer covers (SP) the at least M photodetectors (P1, ..., P8);
- the spacer stack comprises N spacer layers (S1, S2, S3) comprising the first dielectric material, wherein
- the N spacer layers (S1, S2, S3) are patterned and form together with the primary spacer (SP) layer M spacer elements;
- a first spacer element of the M spacer elements consists of a section of the primary spacer layer (SP) covering the first photodetector (P1);
- each the M spacer elements except for the first spacer element comprises segments of a different subset of the N spacer layers (S1, S2, S2) and covers one of the at least M photodetectors (P1, ..., P8).

12. Method for manufacturing an optical sensing device, wherein the method comprises
- providing a semiconductor wafer with a semiconductor substrate (S), the substrate (S) carrying a photodetector array with at least a first and a second photodetector (P1, P2);
- depositing a band-pass filter (BP), depositing a decoupling layer (DL) on the band-pass filter (BP) and depositing a lower dielectric mirror (LM) on the decoupling layer (DL), wherein each of the band-pass filter (BP), the decoupling layer (DL) and the lower dielectric mirror (LM) covers the photodetector array;
- depositing a spacer stack, the deposition of the spacer stack comprising
- depositing on the lower dielectric mirror (LM) a primary spacer layer (SP) comprising a first dielectric material and covering the photodetector array; and
- depositing and structuring by means of a first lift-off sequence a first spacer layer (S1) comprising the first dielectric material, a first segment of the first spacer layer (S1) being arranged on the primary spacer layer (SP) and covering the second photodetector (P2), but not the first photodetector (P1); and
- depositing an upper dielectric mirror (UM) on the spacer stack, wherein
- filter elements are formed by sections of the spacer stack, the lower dielectric mirror (LM) and the upper dielectric mirror (UM), including a first filter element arranged above and covering the first photodetector (P1) and having a first pass wavelength, and a second filter element arranged above and covering the second photodetector (P2) and having a second pass wavelength,
- the first pass wavelength and the second pass wavelength lie within a pass-band of the band-pass filter (BP), and
- the decoupling layer (DL) is adapted to decouple the band-pass filter (BP) from the filter elements, such that a total transmission of one of the filter elements and the band-pass filter (BP) is given by or approximately given by a product of a transmission of the band-pass filter (BP) and a transmission of the respective filter element.

13. Method according to claim 12, wherein
- the photodetector array further comprises a third and a fourth photodetector (P3, P4);
- the deposition of the spacer stack further comprises, before depositing the first spacer layer (S1), depositing and structuring by means of a second lift-off sequence a second spacer layer (S2) comprising the first dielectric material, a first segment of the second spacer layer (S2) being arranged on the primary spacer layer (SP) and covering the third and the fourth photodetector (P3, P4) but none of the first and the second photodetector (P1, P2); and
- a second segment of the first spacer layer (S1) is arranged on the second spacer layer (S2) and covers the fourth photodetector (P4) but none of the first, the second and the third photodetector (P1, P2, P3).

14. Method according to one of claims 12 or 13, wherein
- the photodetector array comprises at least M photodetectors (P1, ..., P8) with M=2^N and N being a positive integer number;
- the primary spacer layer covers the at least M photodetectors (P1, ..., P8);
- the deposition of the spacer stack comprises depositing and structuring by means of N lift-off sequences N spacer layers (S1, S2, S3) comprising the first dielectric material, wherein each of the N spacer layers (S1, S2, S3) covers a different subset of the M photodetectors (P1, ..., P8), each subset comprising M/2 of the at least M photodetectors (P1, ..., P8).

## Patentansprüche

1. Optische Messvorrichtung umfassend ein Halbleitersubstrat (S), das eine Fotodetektoranordnung mit mindestens einem ersten und einem zweiten Fotodetektor (P1, P2) trägt, und einem auf dem Substrat (S) angeordneten und die Fotodetektoranordnung bedeckenden Filterstapel, wobei der Filterstapel umfasst
- ein Bandpassfilter (BP), eine auf dem Bandpassfilter (BP) angeordnete Entkopplungsschicht (DL) und einen auf der Entkopplungsschicht (DL) angeordneten unteren dielektrischen Spiegel (LM), wobei sowohl das Bandpassfilter (BP) als auch die Entkopplungsschicht (DL) und der untere dielektrische Spiegel (LM) die Fotodetektoranordnung bedecken
- einen Abstandshalterstapel umfassend
- eine primäre Abstandsschicht (SP), die auf dem unteren dielektrischen Spiegel (LM) angeordnet ist, ein erstes dielektrisches Material umfasst und die Fotodetektoranordnung bedeckt; und
- eine erste Abstandsschicht (S1), die das erste dielektrische Material umfasst, wobei ein erstes Segment der ersten Abstandsschicht (S1) auf der primären Abstandsschicht (SP) angeordnet ist und den zweiten Fotodetektor (P2), nicht aber den ersten Fotodetektor (P1) bedeckt; und
- einen oberen dielektrischen Spiegel (UM), der auf dem Abstandshalterstapel angeordnet ist, wobei
- Filterelemente durch Abschnitte des Abstandshalterstapels, des unteren dielektrischen Spiegels (LM) und des oberen dielektrischen Spiegels (UM) gebildet werden, einschließlich eines ersten Filterelements, das über dem ersten Fotodetektor (P1) angeordnet ist und diesen bedeckt und eine erste Durchlasswellenlänge aufweist, und eines zweiten Filterelements, das über dem zweiten Fotodetektor (P2) angeordnet ist und diesen bedeckt und eine zweite Durchlasswellenlänge aufweist,
- die erste Durchlasswellenlänge und die zweite Durchlasswellenlänge innerhalb eines Durchlassbandes des Bandpassfilters (BP) liegen, und
- die Entkopplungsschicht (DL) ausgelegt ist, das Bandpassfilter (BP) von den Filterelementen zu entkoppeln, so dass eine Gesamttransmission eines der Filterelemente und des Bandpassfilters (BP) durch ein Produkt aus einer Transmission des Bandpassfilters (BP) und einer Transmission des jeweiligen Filterelements gegeben oder annähernd gegeben ist.

2. Optische Messvorrichtung nach Anspruch 1, wobei die Fotodetektoranordnung ferner einen dritten und einen vierten Fotodetektor (P3, P4) umfasst und der Abstandshalterstapel ferner umfasst
- eine zweite Abstandsschicht (S2), die das erste dielektrische Material umfasst, wobei ein erstes Segment der zweiten Abstandsschicht (S2) auf der primären Abstandsschicht (SP) angeordnet ist und den dritten und den vierten Fotodetektor (P3, P4), aber keinen der ersten und zweiten Fotodetektoren (P1, P2) bedeckt;
- ein zweites Segment der ersten Abstandsschicht (S1), das auf der zweiten Abstandsschicht (S2) angeordnet ist und den vierten Fotodetektor (P4), aber keinen der ersten, zweiten und dritten Fotodetektoren (P1, P2, P3) bedeckt.

3. Optische Messvorrichtung nach einem der Ansprüche 1 oder 2, wobei der untere und der obere dielektrische Spiegel (ML, MU) jeweils aus Spiegelschichten (M1), die das erste dielektrische Material enthalten, und weiteren Spiegelschichten (M2), die ein zweites dielektrisches Material mit einem zweiten Brechungsindex, der sich von einem ersten Brechungsindex des ersten dielektrischen Materials unterscheidet, enthalten, bestehen, wobei die Spiegelschichten (M1) und die weiteren Spiegelschichten (M2) abwechselnd angeordnet sind.

4. Optische Messvorrichtung nach Anspruch 3, wobei zumindest einige der Spiegelschichten (M1) und zumindest einige der weiteren Spiegelschichten (M2) eine Dicke aufweisen, die einem optischen Abstand entspricht, der gleich einem Viertel einer bestimmten Mittenwellenlänge ist.

5. Optische Messvorrichtung nach Anspruch 4, wobei
- ein erstes Filterelement durch einen Abschnitt des unteren dielektrischen Spiegels (LM), der den ersten Fotodetektor (P1) abdeckt, einen Abschnitt der primären Abstandsschicht (SP), der den ersten Fotodetektor (P1) bedeckt, und einen Abschnitt des oberen dielektrischen Spiegels (UM), der den ersten Fotodetektor (P1) bedeckt, gebildet wird; und
- ein zweites Filterelement durch einen Abschnitt des unteren dielektrischen Spiegels (LM), der den zweiten Fotodetektor (P2) abdeckt, einen Abschnitt der primären Abstandsschicht (SP), der den zweiten Fotodetektor (P2) bedeckt, das erste Segment der ersten Abstandsschicht (S1) und einen Abschnitt des oberen dielektrischen Spiegels (UM), der den ersten Fotodetektor (P1) bedeckt, gebildet wird.

6. Optische Messvorrichtung nach Anspruch 5, wobei ein Wert der ersten Durchlasswellenlänge des ersten Filterelements durch eine Dicke der primären Abstandsschicht (SP) bestimmt wird und ein Wert der zweiten Durchlasswellenlänge des zweiten Filterelements durch die Gesamtdicke der primären Abstandsschicht (SP) und der ersten Abstandsschicht (S1) bestimmt wird.

7. Optische Messvorrichtung nach Anspruch 6, wobei die erste Durchlasswellenlänge und die zweite Durchlasswellenlänge innerhalb eines Sperrbandes des unteren dielektrischen Spiegels (LM) und innerhalb eines Sperrbandes des oberen dielektrischen Spiegels (UM) liegen.

8. Optische Messvorrichtung nach einem der Ansprüche 3 bis 7, wobei das Bandpassfilter (BP) aus Bandpassschichten, die das erste dielektrische Material enthalten, und weiteren Bandpassschichten, die das zweite dielektrische Material enthalten, besteht, wobei die Bandpassschichten und die weiteren Bandpassschichten abwechselnd angeordnet sind.

9. Optische Messvorrichtung nach einem der Ansprüche 1 bis 8, wobei der erste und der zweite Fotodetektor (P1, P2) eingerichtet sind, um
- Licht zu detektieren, das auf die optische Erfassungsvorrichtung einfällt und durch den oberen dielektrischen Spiegel (UM), den Abstandshalterstapel und den unteren dielektrischen Spiegel (LM) hindurchgeht; und
- auf der Grundlage des erfassten Lichts ein erstes Kanalsignal bzw. ein zweites Kanalsignal zu erzeugen.

10. Optische Messvorrichtung nach Anspruch 9, die ferner eine Ausleseschaltung umfasst, die dazu ausgelegt ist, dass sie in Abhängigkeit von dem ersten und dem zweiten Kanalsignal mindestens ein Spektralsignal erzeugt, das eine spektrale Zusammensetzung des einfallenden Lichts anzeigt.

11. Optische Messvorrichtung nach einem der Ansprüche 1 bis 10, wobei
- die Fotodetektoranordnung mindestens M Fotodetektoren (P1, ..., P8) umfasst, wobei M=2^N und N eine positive ganze Zahl ist;
- die primäre Abstandsschicht die mindestens M Fotodetektoren (P1, ..., P8) bedeckt (SP);
- der Abstandshalterstapel N Abstandsschichten (S1, S2, S3) umfasst, die das erste dielektrische Material umfassen, wobei
- die N Abstandsschichten (S1, S2, S3) strukturiert sind und zusammen mit der primären Abstandsschicht (SP) M Abstandshalterelemente bilden;
- ein erstes Abstandshalterelement der M Abstandshalterelemente aus einem Abschnitt der primären Abstandsschicht (SP), der den ersten Fotodetektor (P1) bedeckt, besteht;
- jedes der M Abstandshalterelemente mit Ausnahme des ersten Abstandshalterelements aus Segmenten einer anderen Teilmenge der N Abstandsschichten (S1, S2, S2) besteht und einen der mindestens M Fotodetektoren (P1, ..., P8) bedeckt.

12. Verfahren zur Herstellung einer optischen Messvorrichtung, wobei das Verfahren umfasst
- Bereitstellen eines Halbleiterwafers mit einem Halbleitersubstrat (S), wobei das Substrat (S) eine Fotodetektoranordnung mit mindestens einem ersten und einem zweiten Fotodetektor (P1, P2) trägt;
- Abscheiden eines Bandpassfilters (BP), Abscheiden einer Entkopplungsschicht (DL) auf dem Bandpassfilter (BP) und Abscheiden eines unteren dielektrischen Spiegels (LM) auf der Entkopplungsschicht (DL), wobei sowohl das Bandpassfilter (BP), die Entkopplungsschicht (DL) als auch der untere dielektrische Spiegel (LM) die Fotodetektoranordnung bedecken;
- Abscheiden eines Abstandshalterstapels, wobei das Abscheiden des Abstandshalterstapels umfasst
- Abscheiden einer primären Abstandsschicht (SP) auf dem unteren dielektrischen Spiegel (LM), die ein erstes dielektrisches Material umfasst und die Fotodetektoranordnung bedeckt; und
- Abscheiden und Strukturieren einer ersten Abstandsschicht (S1), die das erste dielektrische Material umfasst, mittels einer ersten Lift-off-Sequenz, wobei ein erstes Segment der ersten Abstandsschicht (S1) auf der primären Abstandsschicht (SP) angeordnet ist und den zweiten Fotodetektor (P2), aber nicht den ersten Fotodetektor (P1) bedeckt; und
- Aufbringen eines oberen dielektrischen Spiegels (UM) auf den Abstandshalterstapel, wobei
- Filterelemente durch Abschnitte des Abstandshalterstapels, des unteren dielektrischen Spiegels (LM) und des oberen dielektrischen Spiegels (UM) gebildet werden, einschließlich eines ersten Filterelements, das über dem ersten Fotodetektor (P1) angeordnet ist und diesen bedeckt und eine erste Durchlasswellenlänge aufweist, und eines zweiten Filterelements, das über dem zweiten Fotodetektor (P2) angeordnet ist und diesen bedeckt und eine zweite Durchlasswellenlänge aufweist,
- die erste Durchlasswellenlänge und die zweite Durchlasswellenlänge innerhalb eines Durchlassbandes des Bandpassfilters (BP) liegen, und
- die Entkopplungsschicht (DL) dazu ausgelegt ist, das Bandpassfilter (BP) von den Filterelementen zu entkoppeln, so dass eine Gesamttransmission eines der Filterelemente und des Bandpassfilters (BP) durch ein Produkt aus einer Transmission des Bandpassfilters (BP) und einer Transmission des jeweiligen Filterelements gegeben oder annähernd gegeben ist.

13. Verfahren nach Anspruch 12, wobei
- die Fotodetektoranordnung ferner einen dritten und einen vierten Fotodetektor (P3, P4) umfasst;
- das Abscheiden des Abstandshalterstapels ferner vor dem Abscheiden der ersten Abstandsschicht (S1) das Abscheiden und Strukturieren einer zweiten Abstandsschicht (S2), die das erste dielektrische Material umfasst, mittels einer zweiten Lift-off-Sequenz umfasst, wobei ein erstes Segment der zweiten Abstandsschicht (S2) auf der primären Abstandsschicht (SP) angeordnet ist und den dritten und den vierten Fotodetektor (P3, P4), jedoch keinen der ersten und zweiten Fotodetektoren (P1, P2) bedeckt; und
- ein zweites Segment der ersten Abstandsschicht (S1) auf der zweiten Abstandsschicht (S2) angeordnet ist und den vierten Fotodetektor (P4), aber keinen des ersten, des zweiten und des dritten Fotodetektors (P1, P2, P3) bedeckt.

14. Verfahren nach einem der Ansprüche 12 oder 13, wobei
- die Fotodetektoranordnung mindestens M Fotodetektoren (P1, ..., P8) umfasst, wobei M=2^N und N eine positive ganze Zahl ist;
- die primäre Abstandsschicht die mindestens M Fotodetektoren (P1, ..., P8) bedeckt;
- die Abscheidung des Abstandshalterstapels das Abscheiden und Strukturieren, mittels N Lift-off-Sequenzen, von N Abstandsschichten (S1, S2, S3) umfasst, die das erste dielektrische Material umfassen, wobei jede der N Abstandsschichten (S1, S2, S3) eine andere Teilmenge der M Fotodetektoren (P1, ..., P8) bedeckt, wobei jede Teilmenge M/2 der mindestens M Fotodetektoren (P1, ..., P8) umfasst.

## Revendications

1. Dispositif de détection optique comprenant un substrat semi-conducteur (S) portant un ensemble de photodétecteurs avec au moins un premier et un deuxième photodétecteur (P1, P2) et une pile de filtres disposée sur le substrat (S) et couvrant l'ensemble de photodétecteurs, la pile de filtres comprenant
- un filtre passe-bande (BP), une couche de découplage (DL) disposée sur le filtre passe-bande (BP) et un miroir diélectrique inférieur (LM) disposé sur la couche de découplage (DL), dans lequel le filtre passe-bande (BP), la couche de découplage (DL) et le miroir diélectrique inférieur (LM) couvrent chacun l'ensemble de photodétecteurs;
- une pile d'espacement comprenant
- une couche d'espacement primaire (SP) disposée sur le miroir diélectrique inférieur (LM), comprenant un premier matériau diélectrique et couvrant l'ensemble de photodétecteurs; et
- une première couche d'espacement (S1) comprenant le premier matériau diélectrique, un premier segment de la première couche d'espacement (S1) étant disposé sur la couche d'espacement primaire (SP) et couvrant le deuxième photodétecteur (P2) mais pas le premier photodétecteur (P1); et
- un miroir diélectrique supérieur (UM) disposé sur la pile d'espacement, dans lequel
- des éléments filtrants sont formés par des sections de la pile d'espacement, le miroir diélectrique inférieur (LM) et le miroir diélectrique supérieur (UM), y compris un premier élément filtrant disposé au-dessus et couvrant le premier photodétecteur (P1) et ayant une première longueur d'onde de passage, et un deuxième élément filtrant disposé au-dessus et couvrant le deuxième photodétecteur (P2) et ayant une deuxième longueur d'onde de passage,
- la première longueur d'onde de passage et la deuxième longueur d'onde de passage se situent dans une bande passante du filtre passe-bande (BP), et
- la couche de découplage (DL) est adaptée pour découpler le filtre passe-bande (BP) des éléments filtrants, de sorte qu'une transmission totale de l'un des éléments filtrants et du filtre passe-bande (BP) est donnée par ou approximativement donnée par un produit d'une transmission du filtre passe-bande (BP) et d'une transmission de l'élément filtrant respectif.

2. Dispositif de détection optique selon la revendication 1, dans lequel l'ensemble de photodétecteurs comprend en outre un troisième et un quatrième photodétecteur (P3, P4) et la pile d'espacement comprend en outre
- une deuxième couche d'espacement (S2) comprenant le premier matériau diélectrique, un premier segment de la deuxième couche d'espacement (S2) étant disposé sur la couche d'espacement primaire (SP) et couvrant le troisième et le quatrième photodétecteur (P3, P4) mais aucun du premier et du deuxième photodétecteur (P1, P2);
- un deuxième segment de la première couche d'espacement (S1) étant disposé sur la deuxième couche d'espacement (S2) et couvrant le quatrième photodétecteur (P4) mais aucun du premier, du deuxième et du troisième photodétecteur (P1, P2, P3).

3. Dispositif de détection optique selon l'une des revendications 1 ou 2, dans lequel chacun des miroirs diélectriques inférieur et supérieur (ML, MU) est constitué de couches de miroir (M1), contenant le premier matériau diélectrique et d'autres couches de miroir (M2) contenant un deuxième matériau diélectrique avec un deuxième indice de réfraction différent d'un premier indice de réfraction du premier matériau diélectrique, dans lequel les couches de miroir (M1) et les autres couches de miroir (M2) sont disposées en alternance.

4. Dispositif de détection optique selon la revendication 3, dans lequel au moins certaines des couches de miroir (M1) et au moins certaines des autres couches de miroir (M2) ont une épaisseur correspondant à une distance optique égale à un quart d'une longueur d'onde centrale spécifiée.

5. Dispositif de détection optique selon la revendication 4, dans lequel
- un premier élément filtrant est formé par une section du miroir diélectrique inférieur (LM) couvrant le premier photodétecteur (P1), une section de la couche d'espacement primaire (SP) couvrant le premier photodétecteur (P1) et une section du miroir diélectrique supérieur (UM) couvrant le premier photodétecteur (P1); et
- un deuxième élément filtrant est formé par une section du miroir diélectrique inférieur (LM) couvrant le deuxième photodétecteur (P2), une section de la couche d'espacement primaire (SP) couvrant le deuxième photodétecteur (P2), le premier segment de la première couche d'espacement (S1) et une section du miroir diélectrique supérieur (UM) couvrant le premier photodétecteur (P1).

6. Dispositif de détection optique selon la revendication 5, dans lequel une valeur de la première longueur d'onde de passage du premier élément filtrant est déterminée par une épaisseur de la couche d'espacement primaire (SP) et une valeur de la deuxième longueur d'onde de passage du deuxième élément filtrant est déterminée par épaisseur totale de la couche d'espacement primaire (SP) et de la première couche d'espacement (S1).

7. Dispositif de détection optique selon la revendication 6, dans lequel la première longueur d'onde de passage et la deuxième longueur d'onde de passage se situent dans une bande d'arrêt du miroir diélectrique inférieur (LM) et dans une bande d'arrêt du miroir diélectrique supérieur (UM).

8. Dispositif de détection optique selon l'une des revendications 3 à 7, dans lequel le filtre passe-bande (BP) est constitué de couches passe-bande contenant le premier matériau diélectrique et d'autres couches passe-bande contenant le deuxième matériau diélectrique, dans lequel les couches passe-bande et les autres couches passe-bande étant disposées en alternance.

9. Dispositif de détection optique selon l'une des revendications 1 à 8, dans lequel le premier et le deuxième photodétecteur (P1, P2) sont configurés pour
- détecter la lumière incidente sur le dispositif de détection optique et traversant le miroir diélectrique supérieur (UM), la pile d'espacement et le miroir diélectrique inférieur (LM); et
- pour générer un premier signal de canal et un deuxième signal de canal, respectivement, sur la base de la lumière détectée.

10. Dispositif de détection optique selon la revendication 9, comprenant en outre un circuit de lecture configuré pour générer, en dépendance du premier et du second signaux de canal, au moins un signal spectral indiquant une composition spectrale de la lumière incidente.

11. Dispositif de détection optique selon l'une des revendications 1 à 10, dans lequel
- l'ensemble de photodétecteurs comprend au moins M photodétecteurs (P1, ..., P8) avec M=2^N et N étant un nombre entier positif;
- la couche d'espacement primaire couvre (SP) les au moins M photodétecteurs (P1, ..., P8);
- la pile d'espacement comprend N couches d'espacement (S1, S2, S3) comprenant le premier matériau diélectrique, dans lequel
- les N couches d'espacement (S1, S2, S3) sont modelées et forment avec la couche d'espacement primaire (SP) M éléments d'espacement;
- un premier élément d'espacement des M éléments d'espacement consiste en une section de la couche d'espacement primaire (SP) couvrant le premier photodétecteur (P1);
- chacun des M éléments d'espacement, à l'exception du premier élément d'espacement, comprend des segments d'un sous-ensemble différent des N couches d'espacement (S1, S2, S2) et couvre l'un des au moins M photodétecteurs (P1, ..., P8).

12. Méthode de fabrication d'un dispositif de détection optique, dans laquelle la méthode comprend
- fournir une plaquette semi-conductrice avec un substrat semi-conducteur (S), le substrat (S) portant un ensemble de photodétecteurs avec au moins un premier et un deuxième photodétecteur (P1, P2);
- déposer un filtre passe-bande (BP), déposer une couche de découplage (DL) sur le filtre passe-bande (BP) et déposer un miroir diélectrique inférieur (LM) sur la couche de découplage (DL), dans laquelle le filtre passe-bande (BP), la couche de découplage (DL) et le miroir diélectrique inférieur (LM) couvrent chacun l'ensemble de photodétecteurs;
- déposer une pile d'espacement, le dépôt de la pile d'espacement comprenant
- déposer sur le miroir diélectrique inférieur (LM) une couche d'espacement primaire (SP) comprenant un premier matériau diélectrique et couvrant l'ensemble de photodétecteurs; et
- déposer et structurer au moyen d'une première séquence de décollage une première couche d'espacement (S1) comprenant le premier matériau diélectrique, un premier segment de la première couche d'espacement (S1) étant disposé sur la couche d'espacement primaire (SP) et couvrant le deuxième photodétecteur (P2), mais pas le premier photodétecteur (P1); et
- déposer un miroir diélectrique supérieur (UM) sur la pile d'espacement, dans lequel
- des éléments filtrants sont formés par des sections de la pile d'espacement, du miroir diélectrique inférieur (LM) et du miroir diélectrique supérieur (UM), y compris un premier élément filtrant disposé au-dessus et couvrant le premier photodétecteur (P1) et ayant une première longueur d'onde de passage, et un deuxième élément filtrant disposé au-dessus et couvrant le deuxième photodétecteur (P2) et ayant une deuxième longueur d'onde de passage,
- la première longueur d'onde de passage et la deuxième longueur d'onde de passage se situent dans une bande passante du filtre passe-bande (BP), et
- la couche de découplage (DL) est adaptée pour découpler le filtre passe-bande (BP) des éléments filtrants, de sorte qu'une transmission totale de l'un des éléments filtrants et du filtre passe-bande (BP) est donnée par ou approximativement donnée par un produit d'une transmission du filtre passe-bande (BP) et d'une transmission de l'élément filtrant respectif.

13. Méthode selon la revendication 12, dans laquelle
- l'ensemble de photodétecteurs comprend en outre un troisième et un quatrième photodétecteur (P3, P4);
- le dépôt de la pile d'espacement comprend en outre, avant déposer la première couche d'espacement (S1), déposer et structurer au moyen d'une deuxième séquence de décollage une deuxième couche d'espacement (S2) comprenant le premier matériau diélectrique, un premier segment de la deuxième couche d'espacement (S2) étant disposé sur la couche d'espacement primaire (SP) et couvrant le troisième et le quatrième photodétecteur (P3, P4), mais aucun du premier et du deuxième photodétecteur (P1, P2); et
- un deuxième segment de la première couche d'espacement (S1) est disposé sur la deuxième couche d'espacement (S2) et couvre le quatrième photodétecteur (P4) mais aucun du premier, du deuxième et du troisième photodétecteur (P1, P2, P3).

14. Méthode selon l'une des revendications 12 ou 13, dans laquelle
- l'ensemble de photodétecteurs comprend au moins M photodétecteurs (P1, ..., P8) avec M=2^N et N étant un nombre entier positif;
- la couche d'espacement primaire couvre les au moins M photodétecteurs (P1, ..., P8);
- le dépôt de la pile d'espacement comprend déposer et structurer au moyen de N séquences de décollage N couches d'espacement (S1, S2, S3) comprenant le premier matériau diélectrique, dans lequel chacune des N couches d'espacement (S1, S2, S3) couvre un sous-ensemble différent des M photodétecteurs (P1, ..., P8), chaque sous-ensemble comprenant M/2 des au moins M photodétecteurs (P1, ..., P8).
